# EUROPEAN PATENT APPLICATION

(11) **EP 1 156 371 A2**
(43) Date of publication of application: **21.11.2001**
(21) Application number: 01111240.6
(22) Date of filing: 15.05.2001
(51) Int. Cl.: G03F 7/30

(54) **Replenishing method of planographic printing plate developer**

(30) Priority: 15.05.2000 JP 2000141329
(71) Applicant: FUJI PHOTO FILM CO., LTD., Kanagawa (JP)
(72) Inventor: Kawauchi, Ikuo, Yoshida-cho, Haibara-gun, Shizuoka-ken (JP); Masuda, Takayuki, Yoshida-cho, Haibara-gun, Shizuoka-ken (JP)
(74) Representative: HOFFMANN - EITLE

(57) **Abstract**

A replenishing method of an alkaline processing liquid (planographic printing plate developer) for developing a planographic printing plate making material made of a support having a positive type photosensitive layer for infrared laser, containing (A) a water-insoluble and alkali-soluble polymer material and (B) a compound generating heat upon absorption of light, formed thereon, wherein an aqueous solution of a surface active agent is added to the alkaline processing liquid every time when the development of a predetermined amount of the planographic printing plate making material is carried out, is disclosed. An alkaline agent can be added to the alkaline processing liquid independently from the aqueous solution of the surface active agent.

## Description

### BACKGROUND OF THE INVENTION

### 1. Field of the Invention:

The present invention relates to a replenishing method of a developer, which is carried out at plate making of an image recording material capable of being used as an offset printing master, and particularly to a replenishing method of a developer for a planographic printing plate having formed thereon a photosensitive layer made of a positive type photosensitive composition for infrared laser used for so-called direct plate making capable of directly making a printing plate from digital signals of a computer, etc.

### 2. Description of the Related Art:

Recently, much attention is being directed to a plate making system in which plates are made directly from digital data of a computer without using lith film, etc. The recent development of lasers is remarkable, particularly a solid laser and a semiconductor laser having a light emitting region in the region of from near infrared to infrared, small-sized and high-output lasers are readily available, and these lasers are very useful as light sources for light exposure for the system in which plates are made directly from digital data.

As an image recording material suitable for laser writing, in Japanese Patent Laid-Open No. 285275/1995, a positive type image recording material containing a binder such as a cresol resin, a substance which generates heat upon absorption of light, and a substance which has a thermal decomposing property and substantially lowers the solubility of the binder in the non-decomposed state, such as quinonediazide, is proposed. In the image recording material, by the exposure of an infrared laser, in an exposed area, the substance of generating heat upon absorption of light generates heat and causes the exposed area to be soluble. But, because aluminum which is a support absorbs heat, the thermal efficiency is low, and the solubility in an alkaline development processing liquid in the development step is not satisfactory. Therefore, it may be considered that the concentration of an alkali of the developer is increased, the development processing is carried out with a developer having a high developing ability, that is, under conditions of excess, to increase the solubility of the exposed area. However, a heat-mode printing plate such as a positive type image recording material is low in dissolution resistance of an image area in an alkaline development processing liquid under conditions of excess, and there is a problem that even by a slight scratch on the surface of the photosensitive layer, a defect is formed in the image area.

As means for solving such a problem, for example, in Japanese Patent Laid-Open Nos. 327160/1999, 338126/1999 and 327163/1999, techniques of using an alkaline developer to which a surface active agent has been added are proposed. By using such method, the damage of the image area is less even if an alkaline developer having a high pH is used, and images having an excellent contrast can be formed. Such a development process for planographic printing plates is usually carried out continuously by an automatic processor, and initially, the image formation having the desired quality is possible. But, there is a problem that with the passage of time, the activity of the developer is lowered, and the activity of the surface active agent in the developer is lowered, whereby plate making having a desired contrast becomes difficult.

In general, controlling of the fluctuation of the developing property has been carried out by adding a replenisher to a developer tank. But, when the replenisher having the same composition as in the developer is added, it is difficult to prevent the occurrence of the fluctuation. This is because the surface active agent in the developer causes not only an interaction with the photosensitive layer on the plate surface to be developed but also a reaction with a polymer material of the non-image area dissolved in the developer, whereby the surface active agent is consumed. On the other hand, since the pH of the developer is lowered by the contact with a carbon dioxide gas in air in addition to the development processing the developing property and the protecting property of the image area cannot be well-balanced by only adding the replenisher having a predetermined concentration.

### SUMMARY OF THE INVENTION

An object of the invention is to provide a replenishing method of a planographic printing plate developer capable of continuously plate making a planographic printing plate with a predetermined quality, which can utilize processing apparatus and printing apparatus of the related art as they are, can undergo direct plate making from digital information of a computer, etc., keeps dissolution resistance of image areas in an alkaline processing liquid while ensuring solubility of non-image areas in the alkaline processing liquid, and is excellent in developing stability with respect to an external damage.

As a result of intensive reserches on fluctuation of a developer, the present inventors have found that when an aqueous solution of a surface active agent of a high concentration is added every time when plate making of a predetermined area is carried out, solubility of non-image areas in an alkaline processing liquid and dissolution resistance of image areas can be maintained, and a stable development can be attained over a long period of time, and this discovery led to accomplishment of the invention.

Specifically, the replenishing method of a planographic printing plate developer according to the invention is a replenishing method of an alkaline processing liquid for developing a planographic printing plate making material comprising a support having a positive type photosensitive layer for infrared laser, containing (A) a water-insoluble and alkali-soluble polymer compound and (B) a compound generating heat upon absorption of light, formed thereon, after exposure with an infrared laser, wherein an aqueous solution of a surface active agent is added to the alkaline processing liquid each time the development of a predetermined amount of the planographic printing plate making material is carried out.

Here, it is a preferred embodiment of the invention to add an alkaline agent to the alkaline processing liquid independently from the addition of the aqueous solution of the surface active agent.

The image-forming mechanism in the replenishing method of the developer of the invention is explained.

In the planographic printing plate making material having a photosensitive layer containing a combination of (A) a water-insoluble and alkali-soluble polymer compound (hereinafter, properly referred to as "component (A)") and (B) a compound generating heat upon absorption of light (hereinafter, properly, referred to as "component (B)"), when the photosensitive layer is subjected to a light exposure step by irradiation of an infrared laser, the component (B) generates heat upon absorption of light in the exposed areas, the generated heat lowers a dissolution inhibiting property by an interaction of the component (A) itself, and the exposed areas are removed with an alkaline processing liquid in the development step.

In this case, though the exposed areas are removed by the alkaline processing liquid, in the unexposed areas, the surface active agent contained in the processing liquid adsorbs the alkali-soluble polymer compound (A) and prevents the unexposed areas from being dissolved in the alkaline processing liquid. In the invention, it is estimated that when the surface active agent is additionally added to the processing liquid at the timing of reaching a predetermined processing amount of the planographic printing plate making material in the continuous plate making process, control for always holding the protective function of the unexposed areas is carried out independently from the control of the activity of the developer, whereby maintenance of the stabilized developing property can be attained over a long period of time.

### DESCRIPTION OF THE PEFERRED EMBODIMENTS

The replenishing method of a planographic printing plate developer according to the invention is characterized in that in the case where a step of exposing a planographic printing plate making material by an infrared laser and a step of developing the exposed material with an alkaline processing liquid are continuously carried out, an aqueous solution of a surface active agent is added every time when the plate making treatment of a predetermined number or area of plate making materials or of a predetermined area is carried out.

### (Planographic printing plate making material)

First, the planographic printing plate making material suitably used for the plate making method of the invention is explained. The planographic printing plate making material comprises a support having a positive type photosensitive layer for infrared laser formed thereon, and a composition of forming the photosensitive layer is, hereinafter, referred to as a photosensitive composition.

The planographic printing plate making material, which can be used in the method of the invention, can have, if desired, other layers such as a protective layer, an interlayer, and a back coat layer, in addition to the photosensitive layer.

### (Photosensitive layer)

The positive type photosensitive composition for an infrared laser contained in the photosensitive layer contains (A) a water-insoluble and alkali-soluble polymer compound and (B) a compound generating heat upon absorption of light, and further, if desired, contains other components.

### (A) Water-insoluble and alkali-soluble polymer compound:

There is no particular restriction on the alkali-soluble polymer compound used in the invention, if the compound has hitherto been known. But, a polymer compound having, as a functional group, any of (1) a phenolic hydroxyl group, (2) a sulfonamide group, or (3) an active imide group in a molecule thereof, is preferred.

For example, the following compounds are illustrated, but the invention is not limited to these compounds.
(1) Examples of the polymer compound having a phenolic hydroxyl group include novolak resins such as a phenol-formaldehyde resin, a m-cresol-formaldehyde resin, a p-cresol-formaldehyde resin, a m- and p- mixed cresol-formaldehyde resin, a phenol/cresol (m-, p-, or a m- and p- mixture) mixture-formaldehyde resin, and a phenol/cresol/xylenol mixture-formaldehyde resin, and pyrogallol-acetone resins.
   As the polymer compound having a phenolic hydroxyl group, it is preferred to use a polymer compound having a phenolic hydroxyl group at the side chain, in addition to the foregoing compounds. Examples of the polymer compound having a phenolic hydroxyl group at the side chain include polymer compounds obtained by homopolymerizing a polymerizable monomer made of a low-molecular compound having at least one phenolic hydroxyl group and at least one polymerizable unsaturated bond, or copolymerizing the monomer and other polymerizable monomer.
   Examples of the polymerizable monomer having a phenolic hydroxyl group includes acrylamides, methacrylamides, acrylic acid esters, methacrylic acid esters, and hydroxystyrenes, each having a phenolic hydroxyl group.
   Specific examples of the monomer, which can be suitably used in the invention, include N-(2-hydroxyphenyl)acrylamide, N-(3-hydroxyphenyl)acrylamide, N-(4-hydroxyphenyl)acrylamide, N-(2-hydroxyphenyl)methacrylamide, N-(3-hydroxyphenyl)methacrylamide, N-(4-hydroxyphenyl)methacrylamide, o-hydroxyphenyl acrylate, m-hydroxyphenyl acrylate, p-hydroxyphenyl acrylate, o-hydroxyphenyl methacrylate, m-hydroxyphenyl methacrylate, p-hydroxyphenyl methacrylate, o-hydroxystyrene, m-hydroxystyrene, p-hydroxystyrene, 2-(2-hydroxyphenyl)ethyl acrylate, 2-(3-hydroxyphenyl)ethyl acrylate, 2-(4-hydroxyphenyl)ethyl acrylate, 2-(2-hydroxyphenyl)ethyl methacrylate, 2-(3-hydroxyphenyl)ethyl methacrylate, and 2-(4-hydroxyphenyl)ethyl methacrylate.
   Such resins each having a phenolic hydroxyl group may be used singly or in admixture of two or more thereof.
   Furthermore, as described in U.S. Patent 4,123,279, polycondensates of a phenol having an alkyl group having from 3 to 8 carbon atoms as a substituent and formaldehyde, such as a t-butyl phenol-formaldehyde resin and an octyl phenol-formaldehyde resin, may be used together.
(2) Examples of the alkali-soluble polymer compound having a sulfonamide group include polymer compounds obtained by homopolymerizing a polymerizable monomer having a sulfonamide group or copolymerizing the monomer and other polymerizable monomer.
   Examples of the polymerizable monomer having a sulfonamide group include polymerizable monomers made of a low-molecular compound having at least one sulfonamide group, -NH-SO₂-, having at least one hydrogen atom bonded on the nitrogen atom and at least one polymerizable unsaturated bond in one molecule thereof. Of these monomers, are preferred low-molecular compounds having an acryloyl group, an allyl group or a vinyloxy group, and a substituted or monosubstituted aminosulfonyl group or a substituted sulfonylimino group.
   As such compounds, the compounds represented by the following formulae (I) to (V) are enumerated. 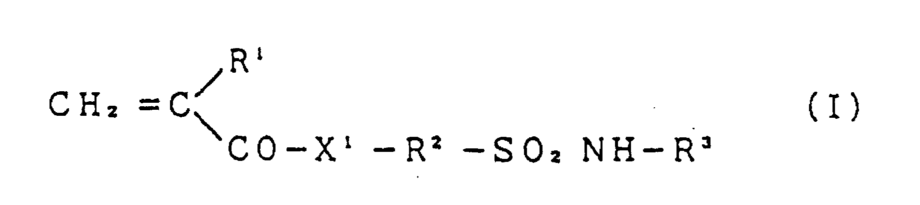 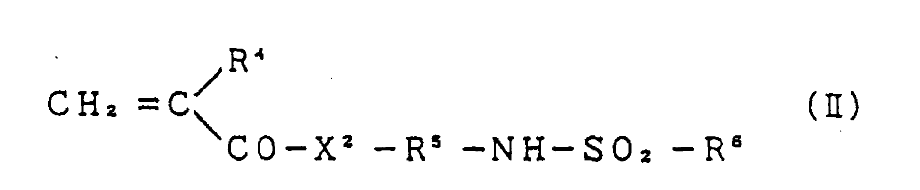 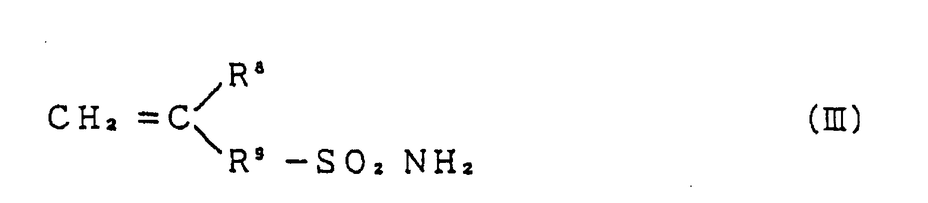 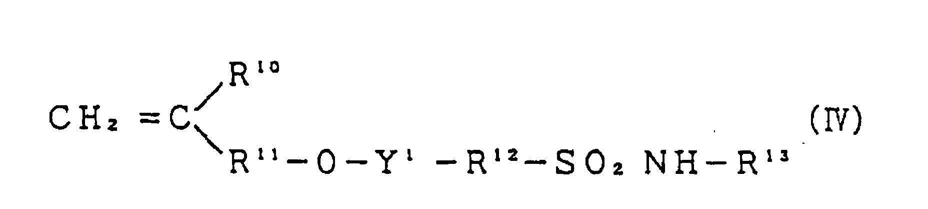 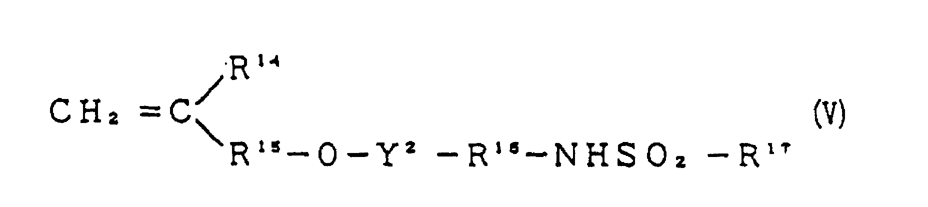
   In the formulae, X¹ and X² each represents -O- or -NR¹-; R¹ and R⁴ each represents a hydrogen atom or -CH₃; R², R⁵, R⁹, R¹², and R¹⁶ each represents an optionally substituted alkylene group, cycloalkylene group, arylene group, or aralkylene group, each having from 1 to 12 carbon atoms; R³, R⁷, and R¹³ each represents a hydrogen atom, an optionally substituted alkyl group, cycloalkyl group, aryl group, or aralkyl group, each having from 1 to 12 carbon atoms; R⁶ and R¹⁷ each represents an optionally substituted alkyl group, cycloalkyl group, aryl group, or aralkyl group, each having from 1 to 12 carbon atoms; R⁸, R¹⁰, and R¹⁴ each represents a hydrogen atom or -CH₃; R¹¹ and R¹⁵ each represents a single bond or an optionally substituted alkylene group, cycloalkylene group, arylene group, or aralkylene group, each having from 1 to 12 carbon atoms; and Y¹ and Y² each represents a single bond or -CO-.
   Specifically, m-aminosulfonylphenyl methacrylate, N-(p-aminosulfonylphenyl) methacrylamide, and N-(p-aminosulfonylphenyl) acrylamide can be suitably used.
(3) As the alkali-soluble polymer compound having an active imide group, is preferred a polymer compound having an active imide group represented by the following formula in a molecule thereof. Examples of such polymer compound includes polymer compounds obtained by homopolymerizing a polymerizable monomer having at least one active imide group represented by the following formula and at least one polymerizable unsaturated bond in one molecule thereof or copolymerizing the polymerizable monomer and other polymerizable monomer.

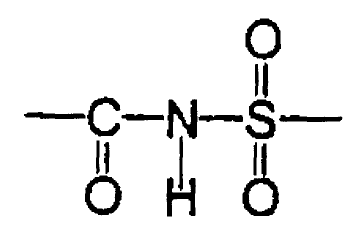

As such compound, N-(p-toluenesulfonyl) methacrylamide and N-(p-toluenesulfonyl) acrylamide can be suitably used.

Furthermore, as the alkali-soluble polymer compound used in the invention, are preferred polymer compounds obtained by polymerizing at least two monomers selected from the polymerizable monomer having a phenolic hydroxyl group, the polymerizable monomer having a sulfonamide group, and the polymerizable monomer having an active imide group, or copolymerizing at least two these polymerizable monomers and other polymerizable monomer.

In the case of copolymerizing the polymerizable monomer having a phenolic hydroxyl group with the polymerizable monomer having a sulfonamide group and/or the polymerizable monomer having an active imide group, a compounding weight ratio of these components is preferably in a range of from 50 : 50 to 5 : 95, and particularly preferably in a range of from 40 : 60 to 10 : 90.

In the invention, when the alkali-soluble polymer compound is a copolymer of the polymerizable monomer having a phenolic hydroxyl group, the polymerizable monomer having a sulfonamide group, or the polymerizable monomer having an active imide group and other polymerizable monomer, the content of the monomer imparting an alkali solubility in the copolymer is preferably at least at least 10 mole %, and more preferably at least 20 mole %. The content of the monomer is less than 10 mole %; the alkali solubility is liable to become insufficient and the effect of improving a development latitude may not be sufficiently attained.

As the monomer component, which is copolymerized with the polymerizable monomer having a phenolic hydroxyl group, the polymerizable monomer having a sulfonamide group, or the polymerizable monomer having an active imide group, the following monomers (1) to (12) can be used, but the invention is not limited to them.
(1) Acrylic acid esters and methacrylic acid esters, each having an aliphatic hydroxyl group, such as 2-hydroxyethyl acrylate and 2-hydroxyethyl methacrylate.
(2) Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, glycidyl acrylate, and N-dimethylaminoethyl acrylate.
(3) Alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, glycidyl methacrylate, and N-dimethylaminoethyl methacrylate.
(4) Acrylamides and methacrylamides, such as acrylamide, methacrylamide, N-methylol acrylamide, N-ethyl acrylamide, N-hexyl methacrylamide, N-cyclohexyl acrylamide, N-hydroxyethyl acrylamide, N-phenyl acrylamide, N-nitrophenyl acrylamide, and N-ethyl-N-phenyl acrylamide.
(5) Vinyl ethers such as ethyl vinyl ether, 2-chloroethyl vinyl ether, hydroxyethyl vinyl ether, propyl vinyl ether, butyl vinyl ether, octyl vinyl ether, and phenyl vinyl ether.
(6) Vinyl esters such as vinyl acetate, vinyl chloroacetate, vinyl butyrate, and vinyl benzoate.
(7) Styrenes such as styrene, α-methylstyrene, methylstyrene, and chloromethylstyrene.
(8) Vinyl ketones such as methyl vinyl ketone, ethyl vinyl ketone, propyl vinyl ketone, and phenyl vinyl ketone.
(9) Olefins such as ethylene, propylene, isobutylene, butadiene, and isoprene.
(10) N-vinylpyrrolidone, N-vinylcarbazole, 4-vinylpyridine, acrylonitrile, methacrylonitrile, etc.
(11) Unsaturated imides such as maleimide, N-acryloyl acrylamide, N-acetyl methacrylamide, N-prpionyl methacrylamide, and N-(p-chlorobenzoyl) methacrylamide.
(12) Unsaturated carboxylic acids such as acrylic acid, methacrylic acid, maleic anhydride, and itaconic acid.

In the invention, when the alkali-soluble polymer compound is a homopolymer or copolymer of the polymerizable monomer having a phenolic hydroxyl group, the polymerizable monomer having a sulfonamide group, or the polymerizable monomer having an active imide group, homopolymers or copolymers having a weight average molecular weight of at least 2,000 and a number average molecular weight of at least 500 are preferred. More preferably, the weight average molecular weight is from 5,000 to 300,000, the number average molecular weight is from 800 to 250,000, and a dispersion degree (weight average molecular weight/number average molecular weight) is from 1.1 to 10.

Also, in the invention, when the alkali-soluble polymer compound is a resin such as a phenol-formaldehyde resin and a cresol-aldehyde resin, those having a weight average molecular weight of from 500 to 20,000 and a number average molecular weight of from 200 to 10,000 are preferred.

These alkali-soluble polymer compounds may be used singly or in admixture of two or more thereof, and the addition amount of the polymer weight compound used is from 30 to 99% by weight, preferably from 40 to 95% by weight, and particularly preferably from 50 to 90% by weight, in the total solid components of the photosensitive layer. When the addition amount of the alkali-soluble polymer compound is less than 30% by weight, the durability of the photosensitive layer is deteriorated, and an addition amount exceeding 99% by weight is undesirable in both the sensitivity and the durability of the photosensitive layer.

### (B) Compound generating heat upon absorption of light:

The compound generating heat upon absorption of light in the invention means a compound having a light-absorbing region in an infrared region of at least 700 nm, and preferably from 750 to 1,200 nm and showing a light/heat conversion function in the light having a wavelength of this range, and specifically, various pigments and dyes generating heat upon absorption of light of this wavelength region can be used.

As the pigments, commercially available pigments and the pigments as described in *Color Index (C. I.) Handbook, "Newest Pigment Handbook"* (edited by The Pigment Technical Society of Japan, 1977), *Newest Pigment Application Technology* (published by CMC, 1986), and *Printing Ink Technology* (published by CMC, 1984) can be utilized.

Examples of the pigment include black pigments, yellow pigments, orange color pigments, brown pigments, red pigments, purple pigments, blue pigments, green pigments, fluorescent pigments, metal powder pigments, and polymer-bonded dyes. Specifically, insoluble azo pigments, azo lake pigments, fused azo pigments, chelate azo pigments, phthalocyanine-based pigments, anthraquinone pigments, perylene-based pigments, perynone-based pigments, thioindigo-based pigments, quinacridone-based pigments, dioxazine-based pigments, isoindolinone-based pigments, quinophthalone-based pigments, dyeing lake pigments, azine pigments, nitroso pigments, nitro pigments, natural pigments, fluorescent pigments, inorganic pigments, carbon black, etc. can be used.

These pigments may be used without applying a surface treatment or may be used after application of a surface treatment. As the method of the surface treatment, there may be considered a method of surface coating the pigment with a resin or a wax; a method of attaching a surface active agent; and a method of bonding a reactive substance (for example, a silane coupling agent, an epoxy compound, and polyisocyanates) to the pigment surface. These surface treatment methods are described in, for example, *Properties and Applications of Metal Soaps* (published by Saiwai Shobo), *Printing Ink Technology* (published by CMC, 1984), and *Newest Pigment Application Technology* (published by CMC, 1986).

The particle size of the pigment is preferably in a range of from 0.01 to 10 µm, more preferably from 0.05 to 1 µm, and particularly preferably from 0.1 to 1 µm. When the particle size of the pigment is smaller than 0.01 µm, it is undesirable from the viewpoint of the stability of the dispersion in the coating liquid of the photosensitive layer, and when it exceeds 10 µm, it is undesirable from the viewpoint of the uniformity of the photosensitive layer.

As a method of dispersing the pigment, known dispersion techniques used for the production of inks and the production of toners can be used. As dispersing apparatus, are employable a ultrasonic dispersing apparatus, a sand mill, an attriter, a pearl mill, a super mill, a ball mill, an impeller, a disperser, a KD mill, a colloid mill, a dynatron, a three-roll mill, and a pressure kneader. Details are described in *Newest Pigment Application Technology* (published by CMC, 1986).

As the dyes, are employable commercially available dyes and known dyes as described in various literatures (for example, *Dye* *Handbook,* edited by The Society of Synthetic Organic Chemistry, Japan, published 1970). Specifically, azo dyes, metal complex salt azo dyes, pyrazolone azo dyes, anthraquinone dyes, phthalocyanine dyes, carbonium dyes, quinoneimine dyes, methine dyes, and cyanine dyes are employable.

In the invention, of these pigments and dyes, those absorbing an infrared light or a near infrared light are particularly preferred from the viewpoint that they are suitable for the utilization by a laser emitting an infrared or a near infrared light.

As such pigment absorbing an infrared light or a near infrared light, carbon black is suitably used. Also, examples of the dye absorbing an infrared light or a near infrared light include cyanine dyes as described in Japanese Patent Laid-Open Nos. 125246/1983, 84356/1984, 202829/1984 and 78787/1985; methine dyes as described in Japanese Patent Laid-Open Nos. 173696/1983, 181690/1983 and 194595/1983; naphthoquinone dyes as described in Japanese Patent Laid-Open Nos. 112793/1983, 224793/1983, 48187/1984, 73996/1984, 52940/1985 and 63744/1985; squarylium dyes as described in Japanese Patent Laid-Open No. 112792/1983; cyanine dyes as described in British Patent 434,875; and dihydroperimidine squarylium dyes as described in U.S. Patent 5,380,635.

Also, as the dyes, near infrared absorbing sensitizing dyes as described in U.S. Patent 5,156,938 are suitably used. Moreover, aryl benzo(thio)pyrylium salts as described in U.S. Patent 3,881,924; trimethinethiapyrylium salts as described in U.S. Patent 4,327,169; pyrylium-based compounds as described in Japanese Patent Laid-Open Nos. 181051/1983, 220143/1983, 41363/1984, 84248/1984, 84249/1984, 146063/1984 and 146061/1984; cyanine dyes as described in Japanese Patent Laid-Open No. 216146/1984; pentamethinethiopyrylium salts as described in U.S. Patent 4,283,475; and pyrylium compounds as described in Japanese Patent Publication Nos. 13514/1993 and 19702/1993, and commercially available products such as Epolight III-178, Epolight III-130, Epolight III-125, and Epolight IV-62A, all manufactured by Epolin, Inc., are particularly preferred.

Also, as particularly preferred other examples of the dyes, are employable near infrared absorbing dyes as described as the formulae (I) and (II) in U.S. Patent 4,756,993.

Examples of preferred cyanine dyes, are enumerated dyes represented by following formula (Z):

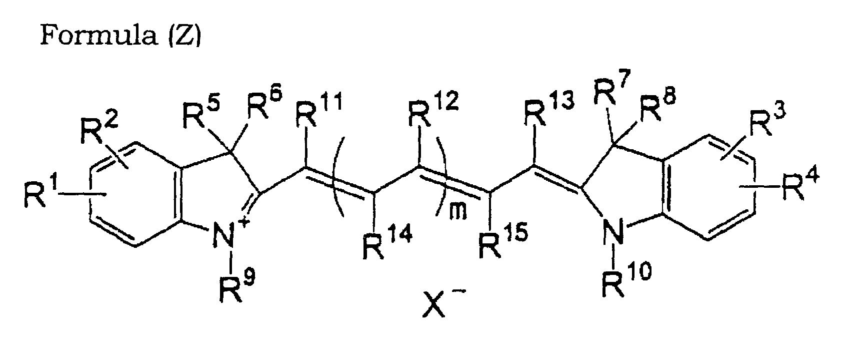

In the formula (Z), R¹ to R⁴ each independently represents a hydrogen atom, or an optionally substituted alkyl group, alkenyl group, alkoxy group, cycloalkyl group, or an aryl group, each having from 1 to 12 carbon atoms; and R¹ and R², and R³ and R⁴, may be respectively bonded to each other to form a ring structure.

Examples of R¹ to R⁴ include a hydrogen atom, methyl, ethyl, phenyl, dodecyl, naphthyl, vinyl, allyl, and cyclohexyl. These groups may further have a substituent, and examples of the substituent include a halogen atom, a carbonyl group, a nitro group, a nitrile group, a sulfonyl group, a carboxyl group, a carboxylic acid ester, and a sulfonic acid ester.

In the formula, R⁵ to R¹⁰ each independently represents an optionally substituted alkyl group having from 1 to 12 carbon atoms, and examples thereof include methyl, ethyl, phenyl, dodecyl, naphthyl, vinyl, allyl, and cyclohexyl. These groups may further have a substituent. In this case, examples of the substituent include a hydrogen atom, a carbonyl group, a nitro group, a nitrile group, a sulfonyl group, a carboxyl group, a carboxylic acid ester, and a sulfonic acid ester.

In the formula, R¹¹ to R¹³ each independently represents a hydrogen atom, a halogen atom, or an optionally substituted alkyl group having from 1 to 8 carbon atoms; R¹² may be bonded to R¹¹ or R¹³ to form a ring structure, and in the case of m > 2, plural R¹²s may be bonded to each other to form a ring structure.

Examples of R¹¹ to R¹³ include a chlorine atom, a cyclohexyl group, or a cyclopentyl or cyclohexyl ring, formed when R¹²s are bonded to each other. These groups may have further a substituent. In this case, examples of the substituent include a halogen atom, a carbonyl group, a nitro group, a nitrile group, a sulfonyl group, a carboxyl group, a carboxylic acid ester, and a sulfonic acid ester.

Also, in the formula, m represents an integer of from 1 to 8, and preferably from 1 to 3.

In the formula, R¹⁴ and R¹⁵ each independently represents a hydrogen atom, a halogen atom, or an optionally substituted alkyl group having from 1 to 8 carbon atoms; R¹⁴ may be bonded to R¹⁵ to form a ring structure; and in the case of m > 2, plural R¹⁴s may be bonded to each other to form a ring structure.

Examples of R¹⁴ and R¹⁵ include a chlorine atom, a cyclohexyl group, or a cyclopentyl or cyclohexyl ring, formed when R¹⁴s are bonded to each other. These groups may have further a substituent. In this case, examples of the substituent include a halogen atom, a carbonyl group, a nitro group, a nitrile group, a sulfonyl group, a carboxyl group, a carboxylic acid ester, and a sulfonic acid ester.

In the formula, X⁻ represents an anion such as perchloric acid, tetrafluoroboric acid, hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoyl-benzenesulfonic acid, and p-toluenesulfonic acid.

Of these anions, are preferred hexafluorophosphoric acid and alkylaromatic sulfonic acids such as triisopropylnaphthalenesulfonic acid and 2,5-dimethylbenzenesulfonic acid.

As the cyanine dyes represented by the formula (Z), specifically, the following compounds are suitably used, but the invention is not limited to these compounds.

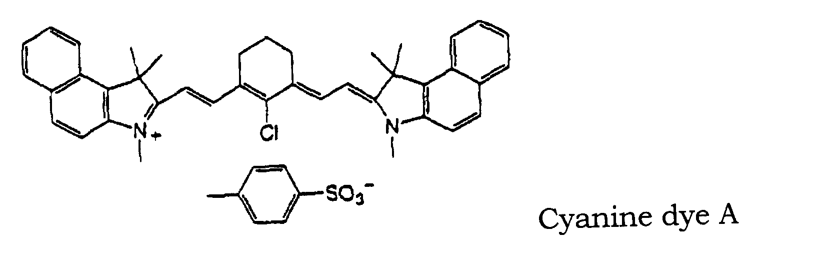

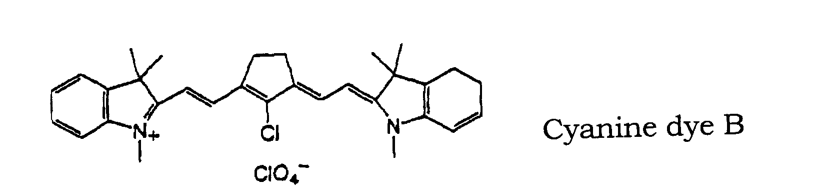

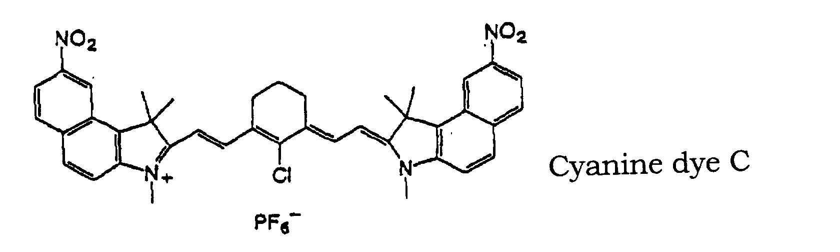

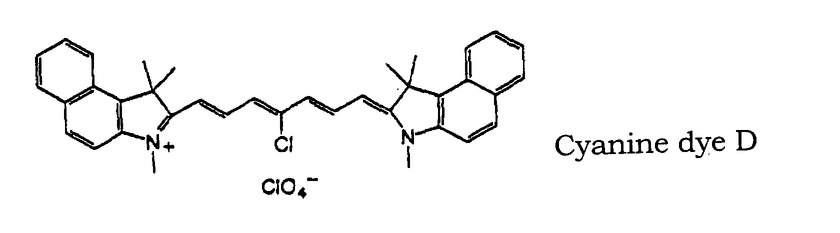

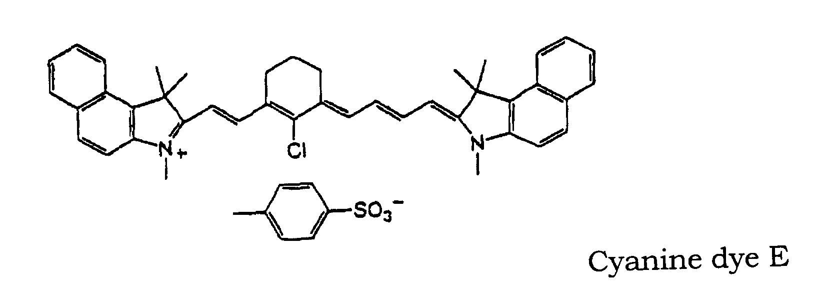

Each of these pigments or dyes can be added to the photosensitive composition in an amount of from 0.01 to 50% by weight, and preferably from 0.1 to 10% by weight to the whole solid components of the photosensitive layer. In the case of the dye, the addition ratio is particularly preferably from 0.5 to 10% by weight, and in the case of the pigment, the addition amount is particularly preferably from 3.1 to 10% by weight. When the addition amount of the pigment or dye is less than 0.01% by weight, the sensitivity is lowered, and when the addition amount exceeds 50% by weight, the uniformity of the photosensitive layer is lost, and the durability of the photosensitive layer is reduced.

The dye or pigment may be added to the same layer containing other components, or to an other layer provided separately. In the case of providing an other layer, it is desirable that the layer is formed adjacent to the layer containing the substance in the invention, which has a thermally decomposing property and substantially lowers the solubility of the alkali-soluble polymer compound in the undecomposed state. Also, it is preferred that the dye or pigment is contained in the same layer containing the alkali-soluble polymer compound, but it may be added to an other layer.

### Other components:

The photosensitive composition in the invention may, if desired, contain various additives. For example, for the purpose of increasing the sensitivity, cyclic acid anhydrides, phenols, organic acids, sulfonyl compounds, quinonediazide compounds, onium salts (such as diazonium salts, ammonium salts, phosphonium slats, and iodonium salts); sulfone compounds, or amide compounds can be added.

The amount of the cyclic acid anhydride, the phenol, the organic acid, or the sulfonyl compound described above in the solid components of the photosensitive composition is preferably from 0.05 to 20% by weight, more preferably from 0.1 to 15% by weight, and particularly preferably from 0.1 to 10% by weight.

Also, the photosensitive composition in the invention can contain nonionic surface active agents as described in Japanese Patent Laid-Open Nos. 251740/1987 and 208514/1991 and amphoteric surface active agents as described in Japanese Patent Laid-Open Nos. 121044/1984 and 13149/1992, for expanding the stability of processing to the development conditions.

The amount of the nonionic surface active agent or the amphoteric surface active agent in the whole solid components of the photosensitive composition is preferably from 0.05 to 15% by weight, and more preferably from 0.1 to 5% by weight.

Also, the photosensitive composition in the invention can contain a printing-out agent for obtaining visible images directly after heating by light exposure and a dye or a pigment as an image-coloring agent.

A typical example of the printing-out agent is a combination of a compound (light/acid-releasing agent) which releases an acid by heating due to light exposure and an organic dye capable of forming a salt.

As the image-coloring agent, in addition to the salt-forming organic dyes as described above, other dyes can be used. As the preferred dyes including the salt-forming organic dyes, are exemplified oil-soluble dyes and basic dyes.

The amount of the dye, which is added to the photosensitive composition, is from 0.01 to 10% by weight, and preferably from 0.1 to 3% by weight of the whole solid components of the photosensitive composition.

Also, the photosensitive composition in the invention can contain, if desired, a plasticizer for imparting flexibility to the coated films. Examples include oligomers and polymers of butylphthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetraflufuryl oleate, acrylic acid, or methacrylic acid.

Furthermore, if desired, the photosensitive composition in the invention may contain a compound, which is decomposed by a light, such as quinonediazides and diazo compounds. The addition amount of the compound is preferably from 1 to 5% by weight to the solid components of the photosensitive composition.

### Production method of photosensitive layer:

The photosensitive layer to which the plate making method of the invention can be applied can be usually produced by coating a solution of the components as described above dissolved in a solvent on a proper support.

Examples of the solvent include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, γ-butyrolactone, and toluene, but the invention is not limited to these solvents. These solvents can be used singly or as a mixture of them.

The concentration of the components (all the solid components including additives) in the solvent is preferably from 1 to 50% by weight. Also, the coating amount (solid components) on the support obtained after coating and drying differs according to the use, but in general, for a photosensitive printing plate, the coating amount is preferably from 0.5 to 5.0 g/m².

As a coating method, various methods can be used. Examples include bar coater coating, rotation coating, spray coating, curtain coating, dip coating, air-knife coating, blade coating, and roll coating. As the coating amount becomes less, the apparent sensitivity is increased, but the film characteristics of the photosensitive film are lowered.

The photosensitive layer can contain a surface active agent such as fluorine-based surface active agents as described in Japanese Patent Laid-Open No. 170950/1987 for improving the coating property of the coating liquid. The addition amount of the surface active agent is from 0.01 to 1% by weight, and preferably from 0.05 to 0.5% by weight of the whole solid components of the photosensitive layer.

### (Support)

The support used in the invention is a plate-form material having a dimensional stability. Examples include papers, papers laminated with a plastic (e.g., polyethylene, polypropylene, and polystyrene), metal plates (e.g., aluminum, zinc, and steel), plastic films (e.g., films of cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, and polyvinyl acetal), and papers or plastic films laminated or vapor deposited with the metal as described above.

As the support, a polyester film or an aluminum plate is preferred, and the aluminum plate having a dimensional stability, which is relatively inexpensive, is particularly preferred. A suitable aluminum plate includes a pure aluminum plate and an aluminum alloy plate made of aluminum as the main constituent and slight amounts of foreign elements, and further, a plastic film laminated or vapor deposited with aluminum may be used. Examples of the foreign elements contained in the aluminum alloy include silicon, iron, manganese, copper, magnesium, chromium, zinc, bismuth, nickel, and titanium. The contents of the foreign elements in the alloy are at most 10% by weight. In the invention, particularly suitable aluminum is pure aluminum, but because it is difficult to produce completely pure aluminum from the metallurgical technique, aluminum containing very slight amounts of foreign elements may be used. As described above, there is no particular restriction on the composition of the aluminum plate used in the invention, and an aluminum plate made of a publicly known and used material can be properly utilized.

The thickness of the aluminum plate is from about 0.1 to 0.6 mm, preferably from 0.15 to 0.4 mm, and particularly preferably from 0.2 to 0.3 mm.

Prior to roughening the surface of the aluminum plate, if desired, a degreasing treatment with, for example, a surface active agent, an organic solvent, or an alkaline aqueous solution, is carried out for removing a rolling oil on the surface thereof.

The roughening treatment of the surface of the aluminum plate is carried out by various methods. For example, roughening is carried out by a method of mechanically roughening, a method of roughening by electrochemically dissolving the surface of the aluminum plate, or a method of chemically dissolving the surface selectively. As the mechanical method, a known method such as a ball polishing method, a brush polishing method, a blast polishing method, and a buff polishing method can be used. Also, as the electrochemical roughening method, a method of carrying out the roughening treatment by an alternating electric current or a direct electric current in a hydrochloric acid or nitric acid electrolyte is employable. Also, a method of combining both the methods as disclosed in Japanese Patent Laid-Open No. 63902/1979 can be utilized.

After applying, if desired, an alkali etching treatment and a neutralization treatment to the aluminum plate roughened as described above, an anodic oxidation treatment is applied to the surface thereof for increasing the water-retention property and the abrasion resistance of the surface, if desired. As the electrolyte used for the anodic oxidation treatment of the aluminum plate, various electrolytes for forming a porous oxide film can be used, and generally, sulfuric acid, phosphoric acid, oxalic acid, chromic acid, or mixed acids thereof are used. The concentration of the electrolyte is properly determined according to the kind of the electrolyte.

The treatment condition of the anodic oxidation cannot be unequivocally defined because the condition changes according to the kind of the electrolyte used, but in general, it is suitable for the concentration of the electrolyte to be from 1 to 80% by weight, the liquid temperature to be from 5 to 70°C, the current density to be from 5 to 60 A/dm², the voltage to be from 1 to 100 volts, and the electrolysis time to be from 10 seconds to 5 minutes.

When the amount of the anodically oxidized film is less than 1.0 g/m², the printing impression is insufficient, and also, the non-image areas of the planographic printing plate are liable to be damaged, whereby so-called "flaw strain" of attaching an ink to the damaged portions at printing becomes liable to occur.

After applying the anodic oxidation treatment, if desired, a hydrophilic treatment is applied to the surface of the aluminum plate. The hydrophilic treatment, may be a method using an alkali metal silicate (for example, aqueous solution of sodium silicate) as disclosed in U.S. Patents 2,714,066, 3,181,461, 3,280,734 and 3,902,734. In this method, the support is dip treated or electrolytically treated with an aqueous solution of sodium silicate. Furthermore, a method of treating the support with fluorinated potassium zirconate as disclosed in Japanese Patent Publication No. 22063/1961 and a method of treating the support with polyvinyl sulfonic acid as disclosed in U.S. Patents 3,276,868, 4,153,461 and 4,689,272 are used.

### (Other layers)

The planographic printing plate making material in the invention is prepared by forming a photosensitive layer by coating the positive type photosensitive composition for infrared laser on a support, but, if desired, a undercoat layer can be formed therebetween as other layer.

As the component for the undercoat layer, various organic compounds are used, and examples of the organic compound include carboxymethyl cellulose; dextrin; gum arabic; phosphonic acids having an amino group, such as 2-aminoethylphosphonic acid; organic phosphonic acids, which may have a substituent, such as phenylphosphonic acid, naphthylphosphonic acid, alkylphosphonic acids, glycerophosphonic acid, methylenediphosphonic acid, and ethylenediphosphonic acid; organic phosphoric acids, which may have a substituent, such as phenylphosphoric acid, naphthylphosphoric acid, alkylphosphoric acids, and glycerophosphoric acid; organic phosphinic acids, which may have a substituent, such as phenylphosphonic acid, naphthylphosphonic acid, alkylphosphinic acids, and glycerophosphinic acid; amino acids such as glycine and β-alanine; and hydrochlorides of amines having a hydroxyl group, such as a hydrochloride of triethanolamine. They may be used as a mixture of two or more of them.

The organic undercoat layer can be formed by the following method. That is, a method of forming by coating a solution of the organic compound dissolved in water or an organic solvent such as methanol, ethanol, and methyl ethyl ketone, or a mixed solvent of them, on an aluminum plate, followed by drying; and a method of dipping an aluminum plate in a solution of the organic compound dissolved in water or an organic solvent such as methanol, ethanol, and methyl ethyl ketone, or a mixed solvent of them, to adsorb the organic compound to the aluminum plate, and washing with water, etc., followed by drying to form the organic undercoat layer, can be used.

In the former method, the solution of the organic compound at a concentration of from 0.005 to 10% by weight can be coated by various methods. Also, in the latter method, the concentration of the solution is from 0.01 to 20% by weight, and preferably from 0.05 to 5% by weight, the dipping temperature is from 20 to 90°C, and preferably from 25 to 50°C, and the dipping time is from 0.1 second to 20 minutes, and preferably from 2 seconds to 1 minute. The pH of the solution used in this method can be controlled in a range of from 1 to 12 by a basic substance such as ammonia, triethylamine, and potassium hydroxide, or an acidic substance such as sulfuric acid and phosphoric acid. Also, a yellow dye can be added to the solution for improving the tone reproducing property of the image recording material.

The coating amount of the organic undercoat layer is suitably from 2 to 200 mg/m², and preferably from 5 to 100 mg/m². When the coating amount is less than 2 mg/m², a sufficient printing impression is not obtained. Also, when the coating amount is higher than 200 mg/m², the same trouble occurs, too.

In the planographic printing plate making material in the invention, if desired, an overcoat layer may be formed on the photosensitive layer. Examples of the component of the overcoat layer include polyvinyl alcohol, methacrylates, acrylates, and matting agents used for an ordinary photosensitive planographic printing plate making material.

### (Plate making process)

### 1. Infrared laser exposing step

The planographic printing plate making material prepared as described above is subjected to light exposure by an infrared laser and a development treatment with an alkaline processing liquid.

The photosensitive layer in the invention has a merit that positive type image formation is possible by an infrared laser. Accordingly, as the light source of the actinic light used for the image exposure, a light source having a light-emitting wavelength of at least 700 nm in the region of from a near infrared light to an infrared light is preferred. As the light source in the plate making method of the invention, a solid laser and a semiconductor laser, capable of emitting infrared rays of from 700 to 1200 nm, are particularly preferred.

### 2. Alkaline processing step and surface active agent replenishing step

In the plate making method of the invention, after light exposure step, the planographic printing plate is subjected to a development step, but in the case of carrying out a continuous development step, an aqueous solution of a surface active agent is replenished at every predetermined processed amount. The concentration of the surface active agent used and the processing amount are properly determined according to the material of the photosensitive layer used and the property of the developer. But, from the viewpoints of the volume of the replenisher tank and the operating property, it is preferred that the concentration of the surface active agent in the aqueous solution of the surface active agent is high as compared with those of the developer and the replenisher, and the concentration is generally from about 1 to 100% by weight, preferably from about 3 to 80% by weight, and particularly preferably from about 5 to 50% by weight. Also, the amount of replenishing at one time is preferably from about 1 to 100 ml.

The timing of replenishing the aqueous solution of the surface active agent may be determined based on a desire to lower the activity of the surface active agent in the processing step, and the means can be employed such that in the case of continuously carrying out plate making of the planographic printing plate of the same size, for example, the plate of about 1000 × 800 mm, the aqueous solution of the surface active agent is added every processing of from 1 to 50 plates, and in the case of continuously processing the planographic printing plates having a different size, the solution is added every processing of from 1 to 50 m² as the surface area of the planographic printing plate processed. In the case of requiring a higher stability, it is preferred to precisely replenish it every processing of a small amount of the plates, and on the other hand, if the stability is to have a relatively wide allowable range, the aqueous solution of the surface active agent may be replenished after processing a round amount. Also, for facilitating replenishing, a method of adding a predetermined amount every unit time can be employed.

There is no particular restriction on the surface active agent used in the invention, and it may be any of an anionic surface active agent, a cationic surface agent, an amphoteric surface active agent, a nonionic surface active agent, and a fluorine-based surface active agent.

Then, the surface active agents, which can be used in the invention, are described successively.

### (Anionic surface active agent)

Suitable examples of the anionic surface active agent include fatty acid salts, abietic acid salts, hydroxyalkanesulfonic acid salts, alkanesulfonic acid salts, dialkylsulfosuccinic acid ester salts, α-olefinsulfonic acid salts, straight-chain alkylbenzenesulfonic acid salts, branched alkylbenzenesulfonic acid salts, alkylnaphthalenesulfonic acid salts, alkylphenoxyoxyethylene propylsulfonic acid salts, polyoxyethylene alkylsulfophenyl ether salts, N-methyl-N-oleyltaurine sodium salts, N-alkylsulfosuccinic acid monoamide disodium salts, petroleum sulfonic acid salts, sulfated tallow oil, sulfuric acid ester salts of fatty acid alkyl esters, alkylsulfuric acid ester salts, polyoxyethylene alkyl ether sulfuric acid ester salts, fatty acid monoglyceride sulfuric acid ester salts, polyoxyethylene alkylphenyl ether sulfuric acid ester salts, polyoxyethylene styrylphenyl ether sulfuric acid ester salts, alkylphosphoric acid ester salts, polyoxyethylene alkyl ether phosphoric acid ester salts, polyoxyethylene alkylphenyl ether phosphoric acid ester salts, partial saponification products of a styrene/maleic anhydride copolymer, partial saponification products of an olefin/maleic anhydride copolymer, and naphthalenesulfonic acid salt-formalin condensates.

### (Cationic surface active agent)

Examples of the cationic surface active agent include alkylamine salts; quaternary ammonium salts such as tetrabutylammonium bromide; polyoxyethylenealkylamine salts; and polyethylene polyamine derivatives.

### (Amphoteric surface active agent)

Examples of the amphoteric surface active agent include carboxybetaines, alkylaminocarboxylic acids, sulfobetaines, aminosulfuric acid esters, and imidazolines.

### (Nonionic surface active agent)

Examples of the nonionic surface active agent include polyoxyethylene alkyl ethers, polyoxyethylene alkylphenyl ethers, polyoxyethylene polystyrylphenyl ethers, polyoxyethylene polyoxypropylene alkyl ethers, glycerol fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylene castor oils, polyoxyethylene glycerol fatty acid partial esters, fatty acid diethanolamides, N,N-bis-2-hydroxyalkylamines, polyoxyethylene alkylamines, triethanolamine fatty acid esters, and trialkylamine oxides.

Specific examples include polyethylene glycol, polyoxyethylene lauryl ether, polyoxyethylene nonyl ether, polyoxyethylene cetyl ether, polyoxyethylene stearyl ether, polyoxyethylene oleyl ether, polyoxyethylene behenyl ether, polyoxyethylene polyoxypropylene cetyl ether, polyoxyethylene polyoxypropylene behenyl ether, polyoxyethylene phenyl ether, polyoxyethylene octylphenyl ether, polyoxyethylene stearylamine, polyoxyethylene oleylamine, polyoxyethylene stearic acid amide, polyoxyethylene oleic acid amide, polyoxyethylene castor oil, polyoxyethylene abietyl ether, polyoxyethylene nonyne ether, polyoxyethylene monolaurate, polyoxyethylene monostearate, polyoxyethylene glyceryl monooleate, polyoxyethylene glyceryl monostearate, polyoxyethylene propylene glycol monostearate, an oxyethylene-oxypropylene block polymer, a distyrenephenol-polyethylene oxide adduct, a tribenzylphenol-polyethylene oxide adduct, an octylphenol-polyoxyethylene-polyoxypropylene adduct, glycerol, monostearate, sorbitan monolaurate, and polyoxyethylene sorbitan monolaurate.

The weight average molecular weight of the nonionic surface active agent is preferably from 300 to 50,000, and particularly preferably from 500 to 5,000.

In the invention, as the nonionic surface active agents, are preferable the compounds represented by following formula (VI):

R¹-O(CH₂CHR²O)_{*l*}-(CH₂CHR³O)ₘ-(CH₂CHR⁴O)ₙ-R⁵ (VI)

In the formula (VI), R¹ to R⁵ each represents a hydrogen atom, an alkyl group having from 1 to 18 carbon atoms, an alkenyl group having from 1 to 18 carbon atoms, an alkenyl group having from 1 to 18 carbon atoms, an aryl group, a carbonyl group, a carboxylate group, a sulfonyl group, or a sulfonate group.

Specific examples of the alkyl group include methyl, ethyl, and hexyl; specific examples of the alkenyl group include vinyl and propenyl; specific examples of the alkenyl group include acetyl and propinyl; and specific examples of the aryl group include phenyl and 3-hydroxyphenyl.

Also, *l*, m, and n each represents an integer of 0 or larger, provided that the sum of *1*, m and n is not 0.

Specific examples of the compound represented by the formula (VI) include homopolymers such as polyethylene glycol and polypropylene glycol and copolymers of, e.g., ethylene glycol, propylene glycol, etc.

The copolymerization ratio of the copolymer as described above is preferably from 10/90 to 90/10 from the viewpoint of both the solubility in the developer and the solubility in the coating liquid. Also, the copolymers are preferably, graft polymers and black polymers are preferred from the viewpoint of both the solubility of the non-image areas in the alkaline developer and the dissolution resistance of the image areas in the alkaline developer.

Of the compounds represented by the formula (VI), a polyoxyethylene/polyoxypropylene block copolymer represented by following formula (VII) is particularly preferred from the viewpoint of the dissolution resistance of the image areas in the alkaline developer.

HO-(C₂H₄O)ₐ-(C₃H₆O)_{b}-(C₂H₄O)_{c}-H (VII)

In the formula (VII), a, b and c each represents an integer of from 1 to 10,000.

For the polymers favorably used in the invention, it is particularly excellent that the percentage of oxyethylene to the whole molecules is from 40 to 80% by weight, and preferably from 40 to 60% by weight and that the molecular weight of polyoxypropylene is in a range of from 1,000 to 4,000, and preferably from 2,000 to 3,500.

### (Fluorine-based surface active agent)

The fluorine-based surface active agent means a surface active agent containing a perfluoroalkyl group in a molecule thereof.

Examples of such fluorine-based surface active agent include anionic surface active agents such as perfluoroalkyl carboxylic acid salts, perfluoroalkyl sulfonic acid salts, and perfluoroalkyl phosphoric acid esters; amphoteric surface active agents such as perfluoroalkyl betaines; cationic surface active agents such as perfluoroalkyltrimethylammonium salts, etc.; and nonionic surface active agents such as perfluoroalkylamine oxides, perfluoroalkylethylene oxide adducts, oligomers containing a perfluoroalkyl group and a hydrophilic group, oligomers containing a perfluoroalkyl group and a lipophilic group, oligomers containing a perfluoroalkyl group, a hydrophilic group and a lipophilic group, and urethanes containing a perfluoroalkyl group and a lipophilic group.

Of the surface active agents, "polyoxyethylene" can be also read as a polyoxyalkylene such as polyoxymethylene, polyoxypropylene, and polyoxybutylene, and they are also included in the surface active agents.

The surface active agents may be used singly or as a combination of two or more of them, if the combination does not deteriorate the effects of the invention.

Then, the alkaline processing liquid, which is suitably used in the continuous development step in the plate making method of the invention, is explained.

It is preferred that the alkaline processing liquid itself contains a surface active agent in addition to a base. This is because the surface active agent forms an interaction with the image area in the development step and can prevent the occurrence of injures in the image areas.

That is, by incorporating a surface active agent in the alkaline processing liquid, the merits are obtained such that even when the development is carried out with a processing liquid having an increased alkali concentration and having a high development ability, that is, under conditions of excess, the dissolution resistance of the image areas in the alkaline processing liquid is maintained, and the development stability to external injuries is improved. This is estimated to be caused by the interaction of the alkali-soluble polymer compound and the surface active agent. The interaction becomes strong, for example, when the nonionic surface active agent used contains an ethylene oxide chain or a propylene oxide chain. This is estimated to be caused by the alkali-soluble group, particularly the phenolic hydroxyl group, forming a strong interaction with the ethylene oxide chain or the propylene oxide chain.

In the invention, there is no particular restriction on the surface active agent, which is added to the alkaline developer, and any of the known ones as given as examples of the replenisher can be used.

The addition amount of the surface active agent to the processing liquid is preferably from 0.001 to 10% by weight, more preferably from 0.01 to 5% by weight, and particularly from 0.03 to 3% by weight.

When the addition amount of the surface active agent is less than 0.001% by weight, the effect of the surface active agent is hard to obtain, while when the addition amount is more than 10% by weight, the developing property tends to lower.

### Base:

The alkaline developer in the invention contains a base as the main constituent.

As the base, any known alkaline agents such as inorganic alkaline agents and organic alkaline agents can be used.

Examples of the inorganic alkaline agent include sodium hydroxide, potassium hydroxide, lithium hydroxide, trisodium phosphate, tripotassium phosphate, triammonium phosphate, disodium phosphate, dipotassium phosphate, diammonium phosphate, sodium carbonate, potassium carbonate, ammonium carbonate, sodium bicarbonate, potassium bicarbonate, ammonium bicarbonate, sodium borate, potassium borate, and ammonium borate.

Examples of the organic alkaline agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine.

The base may be used singly or as a mixture of two or more kinds thereof. Of these bases, are preferred sodium hydroxide and potassium hydroxide. The reason is that by controlling the amount of the base, the pH control is possible over a wide pH range. Also, trisodium phosphate, tripotassium phosphate, sodium carbonate, and potassium carbonate, are preferred because they have a buffering action themselves.

In the invention, for improving the developing property, it is preferred to undergo the processing by increasing the alkali concentration of the alkaline processing liquid, that is, under so-called conditions of excess, and for this purpose, the addition amount of the base may be controlled. That is, the base may be added to the alkaline processing liquid such that the alkaline processing liquid becomes strongly alkaline, for example, the pH becomes from 12.5 to 14.0, and preferably from 12.8 to 13.8.

The alkaline processing liquid in the invention may be a so-called "silicate developer", that is a developer containing an alkali silicate as the base, or containing a mixture of a base and a silicon compound to form an alkali silicate in the system. Also, the alkaline processing liquid may be a so-called "non-silicate developer", which does not contain an alkali silicate but contains a non-reducing sugar and a base.

### Alkali silicate:

Examples of the alkali silicate includes sodium silicate, potassium silicate, lithium silicate, and ammonium silicate. They can be used singly or in combination. The molar ratio of SiO₂/M₂O (wherein, M represents an alkali metal) of the alkali silicate is preferably from 0.3 to 3.0, and particularly preferably from 0.5 to 2.0. When the molar ratio exceeds 3.0, there is a tendency for the developing property to be low. When the molar ratio is lower than 0.3, the alkaline strength becomes higher, and as result the problem of etching of the metals such as the aluminum plate generally used as the support of the photosensitive planographic printing plate making material likely occurs.

The concentration of the alkali silicate in the silicate developer is preferably from 1 to 10% by weight, and particularly preferably from 1.5 to 7% by weight. When the concentration is higher than 10% by weight, precipitates and crystals are liable to form, and because when the waste liquid is neutralized, the liquid is liable to become gelled, whereby the waste liquid treatment becomes complicated. When the concentration is lower than 1% by weight, the developing power and the processing ability are lowered.

### Non-reducing sugar:

When the development process is carried out using a so-called "non-silicate developer", which does not contain an alkali silicate but contains a non-reducing sugar and a base, the receptivity of the photosensitive layer can be maintained in a good state without deteriorating the surface of the photosensitive layer in the infrared-sensitive planographic printing plate making material. Also, the infrared-sensitive planographic printing plate making material is narrow in development latitude and shows a large change of a line image width, etc. by the pH of the developer. But, because the non-silicate developer contains a non-reducing sugar having a buffering property of restraining the fluctuation of the pH, the use of the non-silicate developer is advantageous as compared with the case of a processing liquid containing a silicate. Furthermore, the non-reducing sugar does not easily stain an electric conductivity sensor and a pH sensor because the non-reducing sugar controls the activity of the liquid as compared with the silicate, and at this point, the use of the non-silicate developer is advantageous.

The non-reducing sugar is a saccharide, which neither has a free aldehyde group or ketone group nor shows a reducing property and is classified into a trehalose-type oligosaccharide wherein reducing groups are bonded to each other, a glycoside wherein a reducing group of a saccharide is bonded to a non-saccharide, and a sugar alcohol formed by hydrogenating a saccharide, followed by reduction. Any of these saccharides can be suitably used in the invention. Incidentally, in the invention, non-reducing sugars as described in Japanese Patent Laid-Open No. 305039/1996 can be suitably used.

Examples of the trehalose-type oligosaccharide include saccharose and trehalose.

Examples of the glycoside include alkyl glycosides, phenol glycosides, and mustard oil glycosides.

Examples of the sugar alcohol include D,L-arabitol, ribitol, xylitol, D,L-sorbitol, D,L-mannitol, D,L-iditol, D,L-talitol, dulcitol, and allodulcitol. Furthermore, martitol obtained by hydrogenating martose as a disaccharide and a reductant (reduced millet jelly) obtained by hydrogenating an oligosaccharide are suitably used.

Of these non-reducing sugars, are preferred the trehalose-type oligosaccharides and the sugar alcohols. Among them, D-sorbitol, saccharose, and reduced millet jelly have a buffering action in a proper pH range are preferred from the viewpoint of the cost.

In the invention, these non-reducing sugars may be used singly or as a combination of two or more of them.

The content of the non-reducing sugar in the non-silicate developer is preferably from 0.1 to 30% by weight, and more preferably from 1 to 20% by weight. When the content is less than 0.1% by weight, a sufficient buffering action is not obtained, and when it exceeds 30% by weight, high concentration of the developer is difficult and there is a problem of an increase in cost.

Also, as the base, which is used in combination with the non-reducing sugar, the bases given as examples above can be suitably used. The content of the base in the non-silicate developer is properly determined according to the desired pH, the kind of the non-reducing sugar, the addition amount, etc.

Incidentally, when a reducing sugar is used together with the base, the reducing sugar is colored brown, and the pH is gradually lowered to lower the developing property, and thus, the use of the reducing sugar is undesirable in the invention.

Also, in the invention, as the non-silicate developer, an alkali metal salt of a non-reducing sugar can be used as the main constituent in place of a combination of the reducing sugar and the base for use.

The alkali metal salt of the reducing sugar is obtained by mixing a non-reducing sugar and an alkali metal hydroxide and heating the mixture for dehydration to a temperature higher than the melting point of the non-reducing sugar, or by drying a mixed aqueous solution of a non-reducing sugar and an alkali metal hydroxide.

In the invention, for the non-silicate developer, an alkaline buffer solution made of a weak acid and a base, other than the reducing sugar can be used together.

As the weak acid as described above, an acid having a dissociation constant (pKa) of from 10.0 to 13.1 is preferable, and the weak acid can be selected from weak acids as described in, for example, *IONISATION CONSTANTS OF ORGANIC ACIDS IN AQUEUS SOLUTION,* published by Pergamon Press, Corporation.

Specifically, the following can be given as examples:

Alcohols such as 2,2,3,3-tetrafluoropropanol-1 (pKa: 12.74), trifluoroethanol (pKa: 12.37), and trichloroethanol (pKa: 12.24).

Aldehydes such as pyridine-2-aldehyde (pKa: 12.68) and pyridine-4-aldehyde (pKa: 12.05).

Compounds having a phenolic hydroxyl group, such as salicylic acid (pKa: 13.0), 3-hydroxy-2-naphthoic acid (pKa: 12.84), catechol (pKa: 12.6), gallic acid (pKa: 12.4), sulfosalicylic acid (pKa: 11.7), 3,4-dihydroxysulfonic acid (pKa: 12.2), 3,4-duhydroxybenzoic acid (pKa: 11.94), 1,2,4-trihydroxybenzene (pKa: 11.82), hydroquinone (pKa: 11.56), pyrogallol (pKa: 11.34), o-cresol (pKa: 10.33), resorcinol (pKa: 11.27), p-cresol (pKa: 10.27), and m-cresol (pKa: 10.09).

Oximes such as 2-butanone oxime (pKa: 12.45), acetoxime (pKa: 12.42), 1,2-cycloheptanedione dioxime (pKa: 12.3), 2-hydroxybenzaldehyde oxime (pKa: 12.10), dimethyl glyoxime (pKa: 11.9), ethanediamide dioxime (pKa: 11.37), and acetophenone oxime (pKa: 11.35).

Nucleic acid related substances such as adenosine (pKa: 12.56), inosine (pKa: 12.5), guanine (pKa: 12.3) cytosine (pKa: 12.3), hypoxanthine (pKa: 12.1), and xanthine (pKa: 11.9).

Besides, suitable examples are dimethylaminomethyl phosphonic acid (pKa: 12.32), 1-amino-3,3,3-trifluorobenzoic acid (pKa: 12.29), isopropylidene diphopshonic acid (pKa: 12.10), 1,1-ethylidene diphosphonic acid (pKa: 11.54), 1-hydroxy 1-ethylidene diphosphonate (pKa: 11.52), benzimidazole (pKa: 12.86), thiobenzamide (pKa: 12.8), picoline thioamide (pKa: 12.55), and barbituric acid (pKa: 12.5).

Of these weak acids, are preferred sulfosalicylic acid and salicylic acid.

Examples of the strong base, which is suitably combined with the weak acid include sodium hydroxide, ammonium hydroxide, potassium hydroxide, and lithium hydroxide.

These strong bases may be used singly or as a combination of two or more of them. The strong base is used by controlling the pH within a preferred range by the concentration and combination properly selected.

The alkaline developer used in the invention may, if desired, contain a development stabilizer, an organic solvent, a reducing agent, an organic carboxylic acid, a water softener, a surface active agent, etc., for the purposes of accelerating the development, dispersing development scum and increasing the ink-receptivity of the image areas of the photosensitive planographic printing plate making material. Further, the developer may contain other known components such as an antiseptic, a coloring agent, a thickener, and a defoaming agent.

### Development stabilizer:

Preferred examples of the development stabilizer include polyethylene glycol adducts of sugar alcohol as described in Japanese Patent Laid-Open No. 282079/1994; tetraalkylammonium salts such as tetrabutylammonium hydroxide; phosphonium salts such as tetrabutylphosphonium bromide; and iodonium salts such as diphenyl iodonium chloride.

Also, anionic surface active agents and amphoteric surface active agents as described in Japanese Patent Laid-Open No. 51324/1975; water-soluble cationic polymers as described in Japanese Patent Laid-Open No. 95946/1980; and water-soluble amphoteric polymer electrolytes as described in Japanese Patent Laid-Open No. 142528/1981 are given as examples.

Other examples are organic boron compounds added with an alkylene glycol as described in Japanese Patent Laid-Open No. 84241/1984; water-soluble surface active agents of a polyoxyethylene/polyoxypropylene block polymer type as described in Japanese Patent Laid-Open No. 111246/1985; polyoxyethylene/polyoxypropylene-substituted alkylenediamine compounds as described in Japanese Patent Laid-Open No. 129750/1985; polyethylene glycols having a weight average molecular weight of 300 or more as described in Japanese Patent Laid-Open No. 21554/1986; fluorine-containing surface active agents having a cationic group as described in Japanese Patent Laid-Open No. 175858/1988; and water-soluble ethylene oxide adducts obtained by adding at least 4 mols of ethylene oxide to an acid or an alcohol and water-soluble polyalkylene compounds as described in Japanese Patent Laid-Open No. 39157/1990, etc.

### Organic solvent:

The solubility of the organic solvent, the solubility thereof in water is preferably about 10% by weight or lower, and more preferably 5% by weight or lower.

Specific examples of the organic solvent include 1-phenylethanol, 2-phenylethanol, 3-phenyl-1-propanol, 4phenyl-1-butanol, 4-phenyl-2-butanol, 2-phenyl-1-butanol, 2-phenoxyethanol, 2-benzyloxyethanol, o-methoxybenzyl alcohol, m-methoxybenzyl alcohol, p-methoxybenzyl alcohol, benzyl alcohol, cyclohexanol, 2-methylcyclohexanol, 3-methylcyclohexanol, 4-methylcyclohexanol, N-phenylethanolamaine, and N-phenyldiethanolamine.

The content of the organic solvent in the alkaline processing liquid is from about 0.1 to 5% by weight to the total weight of the alkaline processing liquid.

The content has a close relationship with the content of the surface active agent in the alkaline processing liquid. It is preferred that with an increase of the amount of the organic solvent, the amount of the surface active agent is increased. This is because when the amount of the surface active agent is reduced, and the amount of the organic solvent is increased, the organic solvent is not completely dissolved and the good developing property cannot be ensured.

### Reducing agent:

Examples of the reducing agent include organic reducing agents and inorganic reducing agents. These reducing agents are useful for preventing from the printing plate from being stained.

Preferred specific examples of the organic reducing agent include phenol compounds such as thiosalicylic acid, hydroquinone, Metol, methoxyquinone, resorcinol, and 2-methylresorcinol.; and amine compounds such as phenylenediamine and phenylhydrazine.

Preferred specific examples of the inorganic reducing agents include sodium salts, potassium salts and ammonium salts of inorganic acids, such as sulfurous acid, hydrogensulfite, phosphorous acid, hydrogenphosphite, dihydrogenphosphite, thiosulfuric acid, and dithionous acid. Of these inorganic reducing agents, sulfites are preferred from the viewpoint that they are particularly excellent in the stain preventing effect.

The content of the reducing agent in the alkaline processing liquid is from about 0.05 to 5% by weight to the total amount of the alkaline processing liquid.

### Organic carboxylic acid:

Examples of the organic carboxylic acid include aliphatic carboxylic acids and aromatic carboxylic acids, each having from 6 to 20 carbon atoms.

Specific examples of the aliphatic carboxylic acid having from 6 to 20 carbon atoms include caproic acid, enanthylic acid, caprylic acid, lauric acid, myristic acid, palmitic acid, and stearic acid. Of these acids, alkanoic acids having from 8 to 12 carbon atoms are particularly preferred. They may be unsaturated fatty acids having a double bond in the carbon chain or having branched carbon chains.

Specific examples of the aromatic carboxylic acid having from 6 to 20 carbon atoms include compounds having a carboxyl group substituted to a benzene ring, a naphthalene ring, or an anthracene ring.

More specific examples include o-chlorobenzoic acid, p-chlorobenzoic acid, o-hydroxybenzoic acid, p-hydroxybenzoic acid, o-aminobenzoic acid, p-aminobenzoic acid, 2,4-dihydroxybenzoic acid, 2,5-dihydroxybenzoic acid, 2,6-hydroxybenzoic acid, 2,3-dihydroxybenzoic acid, 3,5-dihydroxybenzoic acid, gallic acid, 1-hydroxy-2-naphthoic acid, 3-hydroxy-2-naphthoic acid, 2-hydroxyl-naphthoic acid, 1-naphthoic acid, and 2-naphthoic acid. Of these acids, hydroxynaphthoic acids are particularly preferred.

It is preferred that the aliphatic carboxylic acids and the aromatic carboxylic acids are used as a sodium salt, a potassium salt, or a ammonium salts, from the viewpoint of increasing the water solubility.

There is no particular restriction on the content of the organic carboxylic acid in the alkaline processing liquid. But, the content is usually from about 0.1 to 10% by weight, and preferably from 0.5 to 4% by weight. When the content is less than 0.1% by weight, the addition effect is insufficient. When it exceeds 10% by weight, an effect corresponding to the increased amount is not obtained, and the dissolution of other additives in the alkaline processing liquid is often prevented.

### Water softener:

Examples of the water softener include polyphosphoric acid and sodium salts, potassium salts and ammonium salts thereof such as aminopolycarboxylic acids (such as ethylenediaminetetraacetic acid, diethylenetriaminepentacetic acid, triethylenetetraminehexaacetic acid, hydroxyethylethylenediaminetriacetic acid, nitrilotriacetic acid, 1,2-diaminocyclohexanetetraacetic acid, and 1,3-diamino-2-propanoltetraacetic acid) and sodium salts, potassium salts and ammonium salts of these acids; and aminotri(methylenesulfonic acid), ethylenediaminetetra(methylenesulfonic acid), diethylenetriaminepenta(methylenephosphonic acid), triethylenetetraminehexa(methylenephosphonic acid), hydroxyethylethylenediaminetri(methylenephosphonic acid), and 1-hydroxyethane-1,1-diphosphonic acid, and sodium salts, potassium salts and ammonium salts of these acids.

The optimum content of the water softener in the alkaline processing liquid varies according to the chelating powder and the hardness and amount of hard water. It is generally from 0.01 to 5% by weight, and preferably from 0.01 to 0.5% by weight. When the content is less than 0.01% by weight, the addition effect is sometimes insufficient, and when it exceeds 5% by weight, adverse influences such as uncolored spots sometimes occurs on the image areas.

The alkaline processing liquid contains water in addition to the components as described above.

In the alkaline processing liquid in the invention, when the liquid is not used (at storing), the liquid is stored as a concentrated liquid by reducing the content of water, and at use, the liquid is diluted with water, which is convenient for the transportation of the alkaline processing liquid. In this case, the concentration degree of the alkaline processing liquid is such that it does not cause the decomposition and deposition of each component.

The printing plate processed using the developer and the replenisher as described above is post-treated with washing water, a rinse solution containing a surface active agent, etc., and a desensitization liquid containing gum arabic or a starch derivative. As the post treatment in the plate making method of a planographic printing plate in the invention, various combinations of these treatments can be used.

Recently, in the plate making/printing fields, for the rationalization and the standardization of the plate making work, an automatic processor for printing plates has been widely used. The automatic processor is generally composed of a development portion and a post-processing portion and comprised of an apparatus for conveying printing plates, each processing liquid tanks, and a spraying apparatus, wherein while conveying exposed printing plates in a horizontal direction, each plate is developed by spraying an amount of processing liquid for each which is sucked up by a pump. Also, recently, a method of processing the printing plates by immersion conveying in a liquid in a processing tank filled with the processing liquid by guide rolls, etc., has been used. In such automatic processing, printing plates can be processed while replenishing the processing liquid with replenisher according to the processing amount and the operation time. Replenishing of the aqueous solution of a surface active agent may be carried out simultaneously with or independent from replenishing of the replenisher.

Also, a so-called throw-away processing system of processing with a substantially unused processing liquid can be applied.

The planographic printing plate obtained as described above can be supplied to a printing step after being coated with a desensitizing gum, but in the case of making a planographic printing plate having a higher printing impression, a burning treatment is applied.

In the case of applying a burning treatment to a printing plate, it is preferred that before the burning treatment, the printing plate is processed with a surface adjusting solution as described in Japanese Patent Publication Nos. 2518/1986 and 28062/1980, and Japanese Patent Laid-Open Nos. 31859/1987 and 159655/1986.

As the method, are applicable a method of coating the surface adjusting solution on the planographic printing plate by a sponge or cotton wool impregnated with the surface adjusting solution, a method of coating by dipping the printing plate in a vat filled with the surface adjusting solution, and a method of coating an automatic coater. Also, it is more preferred to make the coating amount uniform by squeezing or by means of squeezing rollers after coating.

The coating amount of the surface adjusting solution is generally from 0.03 to 0.8 g/m² (dry weight).

After, drying the planographic printing plate coated with the surface adjusting solution, if necessary the planographic printing plate is heated to a high temperature by a burning processor (for example, a burning processor: "BP-1300", available from Fuji Photo Film Co., Ltd.). Though in this case, the heating temperature and the heating time differ according to the kind of the components forming the image, they are preferably in a range of from 180 to 300°C and in a range of from 1 to 20 minutes, respectively.

The planographic printing plate subjected to burning treatment can be, if desired, subjected to the treatments, which have hitherto been carried out, such as water washing and gum coating, but in the case of using the surface adjusting solution containing a water-soluble polymer compound, etc., a so-called desensitization treatment such as gum coating can be omitted.

The planographic printing plate obtained by such treatments is mounted on an offset printing machine, etc. and used for printing a large number of sheets.

### EXAMPLES

Then, the invention is specifically explained by referring to the following Examples, but the invention is not limited to these Examples.

### (Example 1)

### (Preparation of substrates)

After washing with trichloroethylene and degreasing an aluminum plate (a type of material: 1050) of 0.3 mm in thickness, a surface thereof was grained using a nylon brush and an aqueous suspension of 400-mesh pumice and washed well with water. The plate was etched by dipping in a 25% aqueous sodium hydroxide solution at 45°C for 9 seconds. After washing with water, the plate was further dipped in a 20% aqueous nitric acid solution and washed with water. In this case, the etching amount of the grained surface was about 3 g/m². Then, the plate was anodically oxidized with a DC current using 7% sulfuric acid as an electrolyte at a current density of 15 A/dm² to form an anodically oxidized film of 3 g/m², followed by washing with water and then drying.

The plate was treated with a 2.5% by weight aqueous sodium silicate solution at 30°C for 10 seconds and coated with a undercoat liquid as described below, and the coated film was dried at 80°C for 15 seconds to obtain a substrate. After drying, the coating amount was 15 mg/m².

### Composition of undercoat liquid:

· Copolymer as described below having a molecular weight of 28,000 : 0.3 g
· Methanol : 100 g
· Water : 1 g

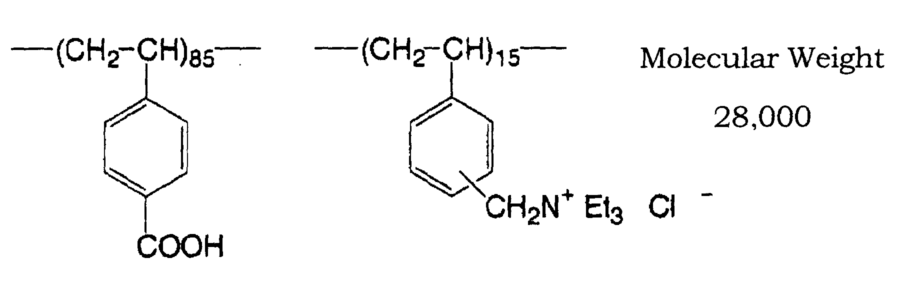

The substrate obtained was coated with the following coating liquid of a photosensitive layer at a coating amount of 1.8 g/m² and dried to obtain a planographic printing plate making material of Example 1.

### (Coating liquid of photosensitive layer)

· m-, p-cresol novolak (m/p ratio = 6/4, weight average molecular weight: 8,000, containing 0.5% by weight unreacted cresol) : 1.0 g
· Cyanine dye A (having a structure show below) : 0.1 g
· Tetrahydrophthalic anhydride : 0.05 g
· p-Toluenesulfonic acid : 0.002 g
· 6-Hydroxy-β-naphthalenesulfonic acid made from the counter ion of Ethyl Violet : 0.02 g
· Fluorine-based surface active agent (Megafac F-177, : 0.05 g manufactured by DAINIPPON INK AND CHEMICALS, INC.)
· Methyl ethyl ketone : 12 g

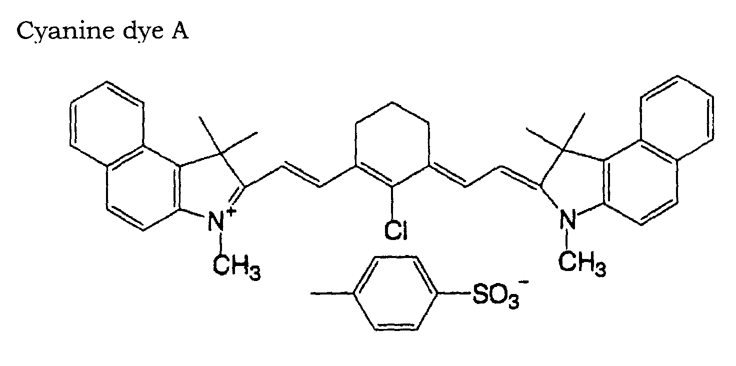

In a developer tank which is a commercially available automatic processor, LP-900H (manufactured by Fuji Photo Film Co., Ltd.) having a dipping type developer tank was placed 2 liters of an alkaline developer A1 (pH about 13) having a composition as described below and kept at 30°C. In a second tank of LP-900H was placed 8 liters of tap water, and in a third tank was placed 8 liters of a finishing gum solution obtained by diluting FP-2W (manufactured by Fuji Photo Film Co., Ltd.) with water at 1 : 1.

### (Composition of alkaline developer A1)

· SiO₂·K₂O (K₂O/Si₂O: 1.1 (molar ratio)) : 4.0 weight %
· Citric acid : 0.5 weight %
· Polyethylene glycol (weight average molecular weight: 1,000) : 0.5 weight %
· Water : 95.0 weight %

A light-exposed planographic printing plate making material 1 (1,030 m × 800 mm × 0.24 mm thick) was processed by LP-900H, while replenishing 80 cc at a time of a development replenisher B1 having a composition as described below for each processing plate and also while replenishing 100 cc of the development replenisher B1 every one hour.

### (Composition of development replenisher B1)

· SiO₂·K₂O (K₂O/Si₂O: 1.1 (molar ratio)) : 5.0 weight %
· Citric acid : 0.6 weight %
· Polyethylene glycol (weight average molecular weight: 1,000) : 0.6 weight %
· Water : 93.8 weight %

The planographic printing plate (1,030 m × 800 mm × 0.24 mm thick) was exposed and developed using a plate setter, Trendsetter 3244F, manufactured by Creo Corporation (output: 9.0 W, revolution number: 150 rpm, resolution degree: 2,400 dpi, image area: about 20%).

In this case, the planographic printing plate was processed while replenishing 5 cc at a time of a development replenisher C1 (an aqueous solution of a nonionic surface active agent) having a composition as described below for each processing of 10 plates.

### (Composition of development replenisher C1)

· Polyethylene glycol (weight average molecular weight: 1,000) : 10.0 weight %
· Water : 90.0 weight %

### (Comparative Example 1)

The development processing was carried out under the same conditions as in Example 1, except that replenishing of the development replenisher C1, which was an aqueous solution of the nonionic surface active agent, was not carried out.

For each of the planographic printing plates of Example 1 and Comparative Example 1 prepared by finishing the development process, the solubility of the non-image areas in the alkaline processing liquid and the dissolution resistance of the image areas in the alkaline processing liquid were evaluated. The evaluation was visually carried out by the following standards. The evaluation results are shown in Table 1 below.

### (Solubility of non-image areas)

○: No residual film is found in the exposed areas.
×: A residual film is found partially in the exposed areas.

### (Dissolution resistance of image areas)

○: Unexposed areas are not dissolved at all in the alkaline processing liquid.
△: Unexposed areas are slightly dissolved in the alkaline processing liquid, and the image density is slightly lowered.
×: Unexposed areas are partially dissolved in the alkaline processing liquid, and the image density is lowered.

**Table 1**

| | Example 1 | | Comparative Example 1 | |
|---|---|---|---|---|
| Number of plates processed | Developing property of non-image areas areas | Remaining of image | Developing property of non-image areas areas | Remaining of image |
| 1 | ○ | ○ | ○ | ○ |
| 50 | ○ | ○ | ○ | ○ |
| 100 | ○ | ○ | ○ | ○ |
| 150 | ○ | ○ | ○ | △ |
| 200 | ○ | ○ | ○ | × |
| 300 | ○ | ○ | ○ | × |
| 400 | ○ | ○ | | |
| 500 | ○ | ○ | | |
| 600 | ○ | ○ | | |
| 700 | ○ | ○ | | |
| 800 | ○ | ○ | | |
| 900 | ○ | ○ | | |
| 1000 | ○ | ○ | | |

As is clear from Table 1, according to the developer replenishing method of the invention, it can be seen that excellent images showing a good on/off property of the image areas and the non-image areas could be formed and the plates were stably processed for continuous processing of up to 1000 plates.

Also, from the results of Comparative Example 1, it can be seen that when replenishing of a surface active agent was not carried out, only 100 plates could be stably developed, and after 150 plates, the image density was lowered by the dissolution of the image areas.

### (Example 2)

The development processing was carried out by the same way as in Example 1, except that an alkaline developer A2, a development replenisher B2 and a development replenisher C2 (an aqueous solution of surface active agent) having compositions as described below were respectively used in place of the alkaline processing developer A1, the development replenisher B1 and the development replenisher C1 (aqueous solution of surface active agent) in the development processing steps in Example 1.

### (Alkaline developer A2)

· D-Sorbitol : 5-0 weight %
· Sodium hydroxide : 2.0 weight %
· Surflon S-121 (quaternary ammonium salt, manufactured by Asahi Glass Co., Ltd.) : 0.5 weight %
· Water : 92.5 weight %

### (Development replenisher B2)

· D-Sorbitol : 6.3 weight %
· Sodium hydroxide : 2.5 weight %
· Surflon S-121 (quaternary ammonium salt, manufactured by Asahi Glass Co., Ltd.) : 0.6 weight %
· Water : 90.6 weight %

### (Development replenisher C2)

· Surflon S-121 (quaternary ammonium salt, manufactured by Asahi Glass Co., Ltd.) : 10.0 weight %
· Water : 90.0 weight %

### (Comparative Example 2)

The development processing was carried out under the same conditions as Example 2 except that replenishing of the development replenisher C2, which was an aqueous solution of the cationic surface active agent, was not carried out.

For each of the planographic printing plates of Example 2 and Comparative Example 2 prepared by finishing the development process, the solubility of the non-image areas in the alkaline processing liquid and the dissolution resistance of the image areas in the alkaline processing liquid were evaluated by the same standards as in Example 1. The evaluation results are shown in Table 2 below.

**Table 2**

| | Example 2 | | Comparative Example 2 | |
|---|---|---|---|---|
| Number of plates processed | Developing property of non-image areas areas | Remaining of image | Developing property of non-image areas areas | Remaining of Image |
| 1 | ○ | ○ | ○ | ○ |
| 50 | ○ | ○ | ○ | ○ |
| 100 | ○ | ○ | ○ | ○ |
| 150 | ○ | ○ | ○ | △ |
| 200 | ○ | ○ | ○ | × |
| 300 | ○ | ○ | ○ | × |
| 400 | ○ | ○ | | |
| 500 | ○ | ○ | | |
| 600 | ○ | ○ | | |
| 700 | ○ | ○ | | |
| 800 | ○ | ○ | | |
| 900 | ○ | ○ | | |
| 1000 | ○ | ○ | | |

As is clear from Table 2, even in the case of using a cationic surface active agent as the surface active agent, according to the developer replenishing method of the invention, it can be seen that excellent images showing a good on/off property of the image areas and the non-image areas could be formed, and the plates were stably processed for continuous processing of up to 1000 plates.

Also, from the results of Comparative Example 2, it can be seen that when replenishing of a surface active agent was not carried out, only 100 plates could be stably developed, and after 150 plates, the image density was lowered by the dissolution of the image areas.

### (Example 3)

The development processing was carried out by the same way as in Example 1, except that an alkaline developer A3, a development replenisher B3 and a development replenisher C3 (aqueous solution of surface active agent) each having compositions as described below were respectively used in place of the alkaline processing developer A1, the development replenisher B1 and the development replenisher C1 (aqueous solution of surface active agent) in the development processing steps in Example 1.

### (Composition of alkaline developer A3)

· SiO₂·K₂O (K₂O/Si₂O: 1 (molar ratio)) : 6.0 weight %
· Trisodium phosphate : 2.0 weight %
· Amogen K (betain type compound, manufactured by DAI-ICHI KOGYO SEIYAKU CO., LTD.) : 0.8 weight %
· water : 91.2 weight %

### (Development replenisher B3)

· SiO₂·K₂O (K₂O/Si₂O: 1 (molar ratio)) : 8.0 weight %
· Trisodium phosphate : 3.0 weight %
· Amogen K (betain type compound, manufactured by DAI-ICHI KOGYO SEIYAKU CO., LTD : 1.0 weight %
· water : 88.0 weight %

### (Development replenisher C3)

· Amogen K (betain type compound, manufactured by DAI-ICHI KOGYO SEIYAKU CO., LTD.) : 15.0 weight %
· Water : 85.0 weight %

### (Comparative Example 3)

The development processing was carried out under the same conditions as in Example 3, except that replenishing of the development replenisher C3, which was an aqueous solution of an amphoteric surface active agent, was not carried out.

For each of the planographic printing plates of Example 3 and Comparative Example 3 prepared by finishing the development process, the solubility of the non-image areas in the alkaline processing liquid and the dissolution resistance of the image areas in the alkaline processing liquid were evaluated by the same standards as in Example 1. The evaluation results are shown in Table 3 below.

**Table 3**

| | Example 3 | | Comparative Example 3 | |
|---|---|---|---|---|
| Number of plates processed | Developing property of non-image areas | Remaining of image areas | Developing property of non-image areas | Remaining of image areas areas |
| 1 | ○ | ○ | ○ | ○ |
| 50 | ○ | ○ | ○ | ○ |
| 100 | ○ | ○ | ○ | ○ |
| 150 | ○ | ○ | ○ | △ |
| 200 | ○ | ○ | ○ | × |
| 300 | ○ | ○ | ○ | × |
| 400 | ○ | ○ | | |
| 500 | ○ | ○ | | |
| 600 | ○ | ○ | | |
| 700 | ○ | ○ | | |
| 800 | ○ | ○ | | |
| 900 | ○ | ○ | | |
| 1000 | ○ | ○ | | |

As is clear from Table 3, even in the case of using an amphoteric surface active agent as the surface active agent, due to the developer replenishing method of the invention, it can be seen that excellent images showing a good on/off property of the image areas and the non-image areas could be formed, and the plates were stably processed for continuous processing of up to 1000 plates.

Also, from the results of Comparative Example 3, it can be seen that when replenishing of a surface active agent was not carried out, only 100 plates could be stably developed, and after 150 plates, the image density was lowered due to the dissolution of the image areas.

### (Example 4)

In the development processing step using the same planographic printing plate making material as in Example 1, 20 liters of an alkaline processing liquid A1 (pH: about 13) having a composition shown below was placed in a development processing tank of a commercially available automatic processor, LP-900H (manufactured by Fuji Photo Film Co., Ltd.) having a dipping type developing tank, and the tank was kept at 30°C. In a second tank was placed 8 liters of tap water, and in a third tank was placed 8 liters of a finishing gum solution obtained by diluting FP-2W (manufactured by Fuji Photo Film Co., Ltd.) with water at 1 : 1.

### (Composition of alkaline developer A1)

· SiO₂·K₂O (K₂O/Si₂O: 1.1 (molar ratio)) : 4.0 weight %
· Citric acid : 0.5 weight %
· Polyethylene glycol (weight average molecular weight: 1,000) : 0.5 weight %
· Water : 95.0 weight %

A light-exposed planographic printing plate (1,030 m × 800 mm × 0.24 mm thick) was processed by LP-900H, while replenishing 100 cc each of a development replenisher B 1 having a composition as described below for each processing of one plate.

### (Composition of development replenisher B1)

· SiO₂·K₂O (K₂O/Si₂O: 1.1 (molar ratio)) : 5.0 weight %
· Citric acid : 0.6 weight %
· Polyethylene glycol (weight average molecular weight: 1,000) : 0.6 weight %
· water : 93.8 weight %

The planographic printing plate (1030 m × 800 mm × 0.24 mm thick) was exposed and developed using a plate setter, Trendsetter 3244F manufactured by Creo Corporation (output: 9.0 W, revolution number 150 rpm, resolution degree: 2,400 dpi, image area: about 20%).

In this case, the planographic printing plate was processed while replenishing 20 cc at a time of a development replenisher C4 (aqueous solution of a nonionic surface active agent) having a composition as described below for each processing of 10 plates.

### (Composition of development replenisher C4)

· SiO₂·K₂O (K₂O/Si₂O: 1.1 (molar ratio)) : 5.0 weight %
· Citric acid : 0.6 weight %
· Polyethylene glycol (weight average molecular weight: 1,000) : 10.0 weight %
· Water : 84.4 weight %

### (Comparative Example 4)

The development processing was carried out under the same conditions as in Example 4, except that replenishing of the development replenisher C4, which was an aqueous solution of the nonionic surface active agent.

For each of the planographic printing plates of Example 4 and Comparative Example 4 prepared by finishing the development process, the solubility of the non-image areas in the alkaline processing liquid and the dissolution resistance of the image areas in the alkaline processing liquid were evaluated by the same standards as in Example 1. The evaluation results are shown in Table 4 below.

**Table 4**

| | Example 4 | | Comparative Example 4 | |
|---|---|---|---|---|
| Number of plates processed | Developing property of non-image areas | Remaining of image areas | Developing property of non-image areas | Remaining of image areas |
| 1 | ○ | ○ | ○ | ○ |
| 50 | ○ | ○ | ○ | ○ |
| 100 | ○ | ○ | ○ | ○ |
| 150 | ○ | ○ | ○ | △ |
| 200 | ○ | ○ | ○ | × |
| 300 | ○ | ○ | ○ | × |
| 400 | ○ | ○ | | |
| 500 | ○ | ○ | | |
| 600 | ○ | ○ | | |
| 700 | ○ | ○ | | |
| 800 | ○ | ○ | | |
| 900 | ○ | ○ | | |
| 1000 | ○ | ○ | | |

As is clear from Table 4, it can be seen that even in the case of adding an alkaline agent to the replenisher in addition to the nonionic active agent, according to the developer replenishing method of the invention using an aqueous solution containing a predetermined amount of the surface active agent as a replenisher, excellent images showing a good on/off property of the image areas and the non-image areas could be formed, and the plates were stably developed for continuous processing of up to 1000 plates.

Also, from the results of Comparative Example 4, it can be seen that when replenishing of a surface active agent was not carried out, only 100 plates could be stably developed, and after 150 plates, the image density was lowered due to the dissolution of the image areas.

As is clear from each of the Examples, by the replenishing method of a developer of the invention, a stabilized developing property can be ensured for a long period of time. But, it can be seen that in a continuous development process, by only adding a replenisher of an alkaline processing liquid containing a predetermined amount of a surface active agent, the developing property, that is the solubility of the non-image areas, can be maintained, but in the case when replenishing of the aqueous solution of a surface active agent is not carried out, balance is not maintained between the solubility of the non-image areas and the protective property of the image areas, and the solubility of the image areas becomes a problem.

According to the replenishing method of a planographic printing plate, the effects are obtained such that the processing apparatus and printing apparatus of the related art can be utilized as they are, direct plate making from a digital information such as a computer is possible, while solving the deficiency of the solubility of the non-image areas in the alkaline processing liquid, the dissolution resistance of the image areas in the alkaline processing liquid is maintained, and planographic printing plates having excellent development stability with respect to external damages can be prepared at a constant quality.

## Claims

1. A method of replenishing a planographic printing plate developer, which is an alkaline processing liquid for developing a material for making planographic printing plate comprising a support having a positive type photosensitive layer for infrared laser, containing (A) a water-insoluble and alkali-soluble polymer compound and (B) a compound generating heat upon absorption of light, formed thereon, after exposing with an infrared laser, wherein:
an aqueous solution of a surface active agent is added to the alkaline processing liquid every time when the development of a predetermined amount of the planographic printing plate making material is carried out.

2. The method of replenishing a planographic printing plate developer according to claim 1, wherein the concentration of the aqueous solution of the surface active agent is from 3 to 80% by weight.

3. The method of replenishing a planographic printing plate developer according to claim 1, wherein the surface active agent dissolved in the aqueous solution of the surface active agent is selected from anionic surface active agents, cationic surface active agents, amphoteric surface active agents, nonionic surface active agents, and fluorine-based surface active agents.

4. The method of replenishing a planographic printing plate developer according to claim 3, wherein a weight average molecular weight of the nonionic surface active agent is from 300 to 50,000.

5. The method of replenishing a planographic printing plate developer according to claim 3, wherein the nonionic surface active agent is represented by the following formula (VI):
R¹-O(CH₂CHR²O)_{*l*}-(CH₂CHR³O)ₘ-(CH₂CHR⁴O)ₙ-R⁵ (VI)
wherein, R¹ to R⁵ each represents a hydrogen atom, an alkyl group having from 1 to 18 carbon atoms, an alkenyl group having from 1 to 18 carbon atoms, an alkinyl group having from 1 to 18 carbon atoms, an aryl group, a carbonyl group, a carboxylate group, a sulfonyl group, or a sulfonate group. *l*, m and n each represents an integer of at least 0, provided that the sum of 1, m, and n is not 0.

6. The method of replenishing a planographic printing plate developer according to claim 5, wherein the nonionic surface active agent represented by the formula (VI) is selected from polyethylene glycol, polypropylene glycol, and a copolymer of ethylene glycol and propylene glycol.

7. The method of replenishing a planographic printing plate developer according to claim 5, wherein the nonionic surface active agent represented by the formula (VI) is a polyoxyethylene/polyoxypropylene block copolymer represented by following formula (VII):
HO-(C₂H₄O)ₐ-(C₃H₆O)_{b}-(C₂H₄O)_{c}-H (VII)
wherein a, b and c each represents an integer of from 1 to 10,000.

8. The method of replenishing a planographic printing plate developer according to claim 1, wherein an alkaline agent is added to the alkaline processing liquid independently from the addition of the aqueous solution of the surface active agent.

9. The method of replenishing a planographic printing plate developer according to claim 8, wherein the alkaline agent is selected from sodium hydroxide, potassium hydroxide, trisodium hydroxide, tripotassium hydroxide, sodium carbonate, and potassium carbonate.
